(19) Europäisches Patentamt

European Patent Office

Office européen des brevets

(11) **EP 0 905 880 B1**

(12) **EUROPÄISCHE PATENTSCHRIFT**

(45) Veröffentlichungstag und Bekanntmachung des Hinweises auf die Patenterteilung:
**19.11.2003 Patentblatt 2003/47**

(51) Int Cl.$^7$: **H03D 7/14**, H03F 3/45

(21) Anmeldenummer: **98116859.4**

(22) Anmeldetag: **07.09.1998**

(54) **Anordnung und Verfahren zur Kompensation des Offsets eines Mischers**

Device and method for the offset voltage compensation of a mixer

Dispositif et procédé de compensation de la tension d' offset d' un mélangeur

(84) Benannte Vertragsstaaten:
**DE FI FR GB SE**

(30) Priorität: **30.09.1997 DE 19743272**

(43) Veröffentlichungstag der Anmeldung:
**31.03.1999 Patentblatt 1999/13**

(73) Patentinhaber: **Infineon Technologies AG**
**81669 München (DE)**

(72) Erfinder:
• **Sehrig, Peter**
  **82343 Pöcking (DE)**
• **Arzt, Andreas**
  **82024 Taufkirchen (DE)**

(74) Vertreter: **Epping Hermann & Fischer**
**Ridlerstrasse 55**
**80339 München (DE)**

(56) Entgegenhaltungen:
EP-A- 0 693 823          GB-A- 2 191 009
US-A- 4 827 222          US-A- 4 987 327

• **"VERSTAERKER ZUR VERSTAERKUNG KLEINER STROEME" RESEARCH DISCLOSURE, Nr. 338, 1. Juni 1992, Seiten 519-522, XP000315729**

## Beschreibung

Die in den Ansprüchen 1-9 definierte Erfindung betrifft eine Anordnung und ein Verfahren zur Kompensation des Offsets eines Mischers und der nachfolgenden Schaltungen für Mobilfunkanwendungen.

Bei einem für den Mobilfunk verwendeten Empfängerbaustein wird ein an der Antenne anliegendes Empfangssignal, im folgenden auch als Nutzsignal bezeichnet, erst in ein Signal mit einer Zwischenfrequenz und anschließend mittels eines Demodulators in das Basisband umgesetzt. In dem beschriebenen Empfangspfad können nun fertigungsbedingt Offsetspannungen auftreten. Diese werden durch die im Empfangspfad enthaltenen Verstärker ebenso wie das Nutzsignal verstärkt. Liegt am Eingang eines 30 dB-Verstärkers z. B. eine Offsetspannung von 10 mV an, so ergibt das eine Offsetspannung von ca. 320 mV am Ausgang des 30 dB-Verstärkers. Dies führt zur Begrenzung des Nutzsignals, da durch die Offsetspannung der Aussteuerbereich des Verstärkers und aller nachfolgenden Verstärker verringert wird.

In allen hochfrequenten Schaltungsteilen, wobei hier sowohl der Hochfrequenz- als auch der Zwischenfrequenzpfad gemeint ist, kann die Offsetspannung an geeigneten Stellen durch kapazitive Kopplung eliminiert werden. Anders ist dies im Basisband, weil hier die Grenzfrequenz bei ca. 100 kHz liegt. Eine kapazitive Kopplung ist hier nicht mehr möglich, da sehr große Kapazitäten verwendet werden müßten. Große Kapazitäten benötigen jedoch beim Einschalten des integrierten Schaltkreises sehr lange Aufladezeiten und beanspruchen z. T. erhebliche Einbaufläche auf der Leiterplatte. Eine Integration der Kapazitäten auf den integrierten Schaltkreis ist bisher nicht möglich.

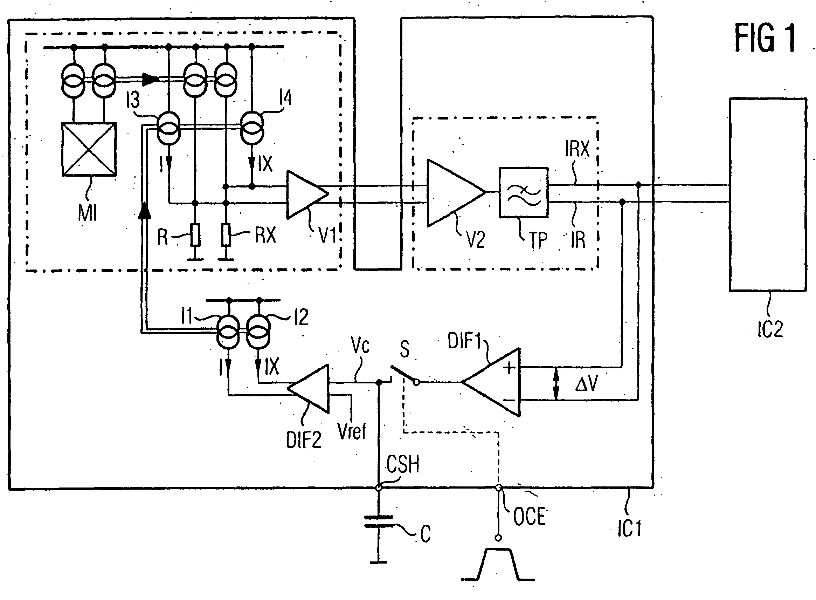

Bisher wurde eine Offsetkompensation im Basisband mit Hilfe einer Sample & Hold Schaltung realisiert siehe z.B. der Dokument EP-A-0 693 823. Die entsprechende Anordnung ist in Figur 1 gezeigt. Der Empfängerbaustein, mit Schaltkreis IC1 bezeichnet, weist einen im Empfangspfad befindlichen Mischer MI auf, der das Signal mit der Zwischenfrequenz fZF in das Basisband umsetzt. Das differentielle Basisbandsignal wird mittels des ersten Verstärkers V1 verstärkt und einen zweiten Verstärker V2, sowie einem Tiefpaß TP zugeführt. Die Ausgänge des Tiefpasses TP führen auf zwei Anschlußklemmen des ersten integrierten Schaltkreises IC1. Diese sind gemäß Figur 1 mit einem zweiten integrierten Schaltkreis IC2 verbunden, welcher ein Basisbandcodec ist. Zusätzlich ist der Tiefpaß TP mit dem auf dem ersten integrierten Schaltkreis IC1 befindlichen ersten Differenzverstärker DIF1 verbunden. Mittels des ersten Differenzverstärkers DIF1 wird die am Basisbandausgang des ersten integrierten Schaltkreises IC1 vorliegende Offsetspannung $\Delta V$ erfaßt. Der ermittelte Offset $\Delta V$ wird durch einen externen Kondensator C gespeichert. Der Kondensator C wird abhängig von der Schalterstellung des Schalters S, welcher durch ein am Eingang OCE anliegendes Signal gesteuert wird, periodisch geladen. Der im Kondensator C gespeicherte Offset wird mittels eines zweiten Differenzverstärkers DIF2 mit einer Referenzspannung Vref verglichen. Das Differenzsignal zwischen gespeicherten Offset Vc und Referenzspannung Vref dient zur Steuerung der Stromquellen I1 und I2. Diese sind mit Stromquellen I3 und I4 gekoppelt, die einen entsprechenden Offsetkompensationsstrom I beziehungsweise IX erzeugen, um den Offset des Mischers MI zu kompensieren.

Der Differenzverstärker DIF1 lädt oder entlädt, je nach Polarität des vom Mischer MI erzeugten Offsets den externen Kondensator C. Die von den Stromquellen I3 und I4 erzeugten Offsetkompensationsströme I und IX wirken dem vom Mischer MI erzeugten Offset entgegen. Da sich der Kondensator C, bedingt durch Leckströme, wieder entlädt, muß der Ladevorgang bei jedem Empfangszeitschlitz, d. h. bei GSM alle 500 μs wiederholt werden. Diese Realisierung benötigt je einen Ladekondensator für den Inphase und den Quadraturkanal. Zusätzlich ist ein Eingang zur Aktivierung der Sample & Hold Schaltung notwendig. Das bedeutet, daß zwei externe Bauteile (Kondensatoren) sowie drei Pins am ersten integrierten Schaltkreis IC1 notwendig sind.

Eine Aufgabe der Erfindung ist es, eine Anordnung und ein Verfahren zur Kompensation des Offsets eines Mischers anzugeben, bei der auf externe Bauelemente verzichtet werden kann. Weiterhin soll die Anzahl der notwendigen Anschlüsse (Pins) so gering wie möglich gehalten werden.

Die Aufgabe wird durch eine Anordnung gemäß Patentanspruch 1 und durch ein Verfahren gemäß Patentanspruch 8 gelöst.

Die erfindungsgemäße Anordnung zur Kompensation des Offsets eines Mischers weist einen ersten integrierten Schaltkreis auf, der den Mischer und eine Stelleinheit zur Erzeugung eines Offsetkompensationssignals aufweist, welche mit dem Mischer verbunden ist. Weiterhin ist ein Bus und ein zweiter integrierter Schaltkreis vorgesehen, der ein Mittel zur Erfassung des Offsets des Mischers aufweist und den erfaßten Offset auf den Bus ausgibt. Der Offset wird über den Bus der Stelleinheit zugeführt.

Vorteilhafte Weiterbildungen ergeben sich aus den abhängigen Ansprüchen.

So kann die Stelleinheit beispielsweise eine oder mehrere einstellbare Stromquellen aufweisen.

Die einstellbare Stromquelle wiederum kann mehrere zuschaltbare parallel zueinander geschaltete Konstantstromquellen aufweisen.

Anstelle der einstellbaren Stromquellen kann die Stelleinheit auch mehrere in Reihe geschaltete Widerstände und mehrere zuschaltbare Stromquellen aufweisen, die mit den Widerständen derart verbunden sind, daß verschiedene Spannungen einstellbar sind.

Die Anordnung kann einen Speicher aufweisen, in den der Offsetkompensationswert geschrieben wird.

Der Speicher kann ein nicht flüchtiges Element sein, beispielsweise in Form eines ROMs.

Vorteilhafter Weise ist der Bus ein 3-Leiter-Bus.

Bei dem Verfahren zur Kompensation des Offsets eines Mischers wird der Mischer, welcher Bestandteil eines ersten integrierten Schaltkreises ist, ohne Eingangssignal betrieben und der Offset des Ausgangssignals des Mischers mit einem Mittel zur Erfassung des Offsets des Mischers, welches Bestandteil eines zweiten integrierten Schaltkreises ist, erfasst. Der erfasste Offset wird über einen Bus an eine Stelleinheit, welche Bestandteil des ersten integrierten Schaltkreises ist, übermittelt. Die Stelleinheit (SE) führt einen entsprechenden Offsetkompensationswert dem Mischer (MI) zu.

Weiterhin kann bei dem Verfahren der erfasste Offset in einen nichtflüchtigen Speicher geschrieben werden. Der im Speicher stehende Offset wird bei einer Inbetriebnahme des ersten integrierten Schaltkreises ausgelesen und über den Bus der Stelleinheit zur Verfügung gestellt.

Die Erfindung wird anhand von drei Figuren weiter erläutert.

Figur 1    zeigt die Kompensation des Offsets gemäß dem Stand der Technik.

Figur 2    zeigt eine erste erfindungsgemäße Ausführungsform der Anordnung zur Kompensation des Offsets eines Mischers.

Figur 3    zeigt eine zweite erfindungsgemäße Ausführungsform der Anordnung zur Kompensation des Offsets eines Mischers.

Auf die Kompensationsanordnung gemäß Figur 1 wurde bereits in der Beschreibungseinleitung eingegangen.

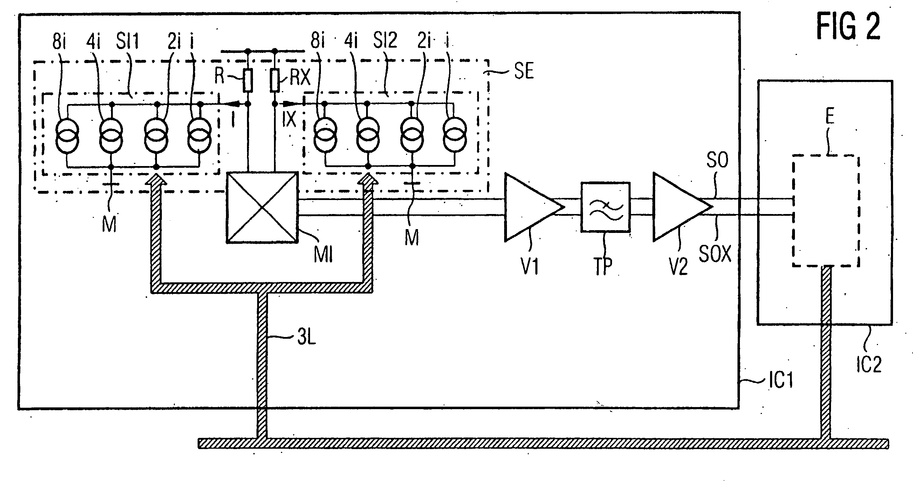

In Figur 2 ist dem ersten integrierten Schaltkreis IC1, welcher ein Empfängerbaustein ist, ebenso wie in Figur 1 ein zweiter integrierter Schaltkreis IC2 nachgeschaltet. Der zweite integrierte Schaltkreis IC2 ist ein Basisbandcodec. Er dient zur Bearbeitung der Basisbandsignale. Entgegen der in Figur 1 gezeigten Realisierung erfolgt die Messung des vom Mischer MI stammenden Offsets mittels der Erfassungseinheit (E) im zweiten integrierten Schaltkreis IC2, dem Basisbandbaustein. Dabei wird bei nicht angelegtem Nutzsignal, d. h. der Mischer MI erhält kein Eingangssignal, die Öffsetspannung, die am Ausgang des ersten integrierten Schaltkreises IC1 anliegt, gemessen und je nach Größe der Offsetspannung akwerden über einen 3-Leiter-Bus entsprechende Stromquellen aktiviert. Der 3-Leiter-Bus 3L ist im gesamten System verfügbar und verbindet unter anderem den ersten integrierten Schaltkreis IC1 mit dem zweiten integrierten Schaltkreis IC2.

Durch eine derartige Anordnung besteht die Möglichkeit auch neben der Offsetkompensation weitere Meß-, Steuer- und Regelvorgänge über den 3-Leiter-Bus 3L zu koordinieren.

Die in Figur 2 gezeigten steuerbaren Stromquellen SI1 und SI2 beinhalten jeweils vier Konstantstromquellen, die die Ströme i, 2i, 4i und 8i erzeugen. Abhängig von den Steuersignale, das über den 3-Leiter-Bus 3L an die steuerbaren Stromquellen SI1 und SI2 übertragen werden, werden entsprechende Ströme, die zwischen i und 15i liegen können eingestellt.

Die beiden Stromquellen SI1 und SI2 sind Bestandteil einer Stelleinheit SE. Diese dient zur Einstellung des Offsetkompensationsstroms.

Die steuerbaren Stromquellen SI1 und SI2 sind einerseits mit einem Bezugspotential M und andererseits sowohl mit dem Mischer MI als auch einem Widerstand R bzw. RX verbunden. Die Widerstände R und RX sind die Arbeitswiderstände des Mischers MI.

Dabei bestimmt sich die kompensierbare Offsetspannung durch die von den einstellbaren Stromquellen SI1 und SI2 eingestellten Ströme I bzw. IX und durch die Arbeitswiderstände R bzw. RX. Das Produkt aus i x R und das Produkt aus i x RX bestimmen die minimal kompensierbare Offsetspannung. Der maximal einprägbare Strom, der durch die erste einstellbare Stromquelle SI1 erzeugbar ist, beträgt 15 x i. Das gleiche gilt für den maximal einstellbaren Strom der zweiten einstellbaren Stromquelle SI2. Daraus ergibt sich die maximal kompensierbare Offsetspannung zu 15 x i x R bzw. 15 x i x RX.

Das Mischerausgangssignal wird mittels des ersten Verstärkers V1 verstärkt, durch den Tiefpaßfilter TP gefiltert und anschließend durch den zweiten Verstärker V2 erneut verstärkt. Das Ausgangssignal des zweiten Verstärkers V2 ist an den Ausgängen SO und SOX des ersten integrierten Schaltkreises IC1 abgreifbar.

Vorteilhafterweise fallen bei dieser Ausführungsform gegenüber der in Figur 1 gezeigten Anordnung die Kapazitäten und die zusätzlich notwendigen Anschlüsse CSH und OCE weg.

Zusätzlich können durch den 3-Leiter-Bus 3L weitere Meß-, Steuer- und Regelvorgänge koordiniert werden.

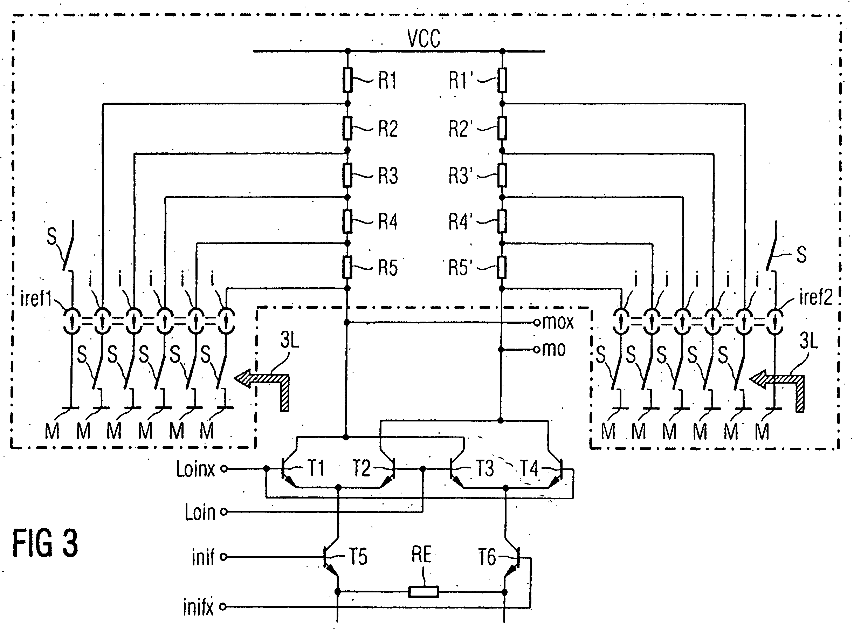

Bei der in Figur 3 gezeigten Ausführungsform sind die erste Stromquelle SI1 und die zweite Stromquelle SI2 durch ein Widerstands-Stromquellennetzwerk ersetzt worden. Das Widerstands-Stromquellennetzwerk dient als Stelleinheit SE. Dazu sind fünf Widerstände R1 bis R5 in Reihe geschaltet. Der freie Anschluß des Widerstands R1 ist mit einem Versorgungspotential VCC verbunden. Der freie Anschluß des Widerstands R5 ist sowohl mit dem Mischerausgang mox als auch dem Kollektor eines Transistors T1 und dem Kollektor eines Transistors T3, welche Bestandteile des Mischers MI sind, verbunden. Weiterhin sind die Widerstände R1 bis R5 über jeweils eine Stromquelle, die einen Konstantstrom i liefert und über jeweils einen Schalter, der mit der entsprechenden Stromquelle in Reihe geschaltet ist, mit dem Bezugspotential M verbunden. Die Stromquellen, die jeweils den Strom i liefern, sind mit einer Stromquelle, die einen Referenzstrom iref1 einprägt, gekoppelt. Der Pfad für das invertierte Signal ist symmetrisch zu dem gerade beschriebenen Pfad für das Inphasesignal aufgebaut. Die Widerstände im Pfad für das invertierte Signal sind mit R1' bis R5' bezeichnet. Die Referenzstromquelle liefert den Referenzstrom iref2, welcher gleich dem ersten Referenzstrom iref1 sein kann. Der Widerstand R5' ist mit dem Ausgang mo des Mischers MI, dem Kollektor eines zweiten Transistors T2 und dem Kollektor eines vierten Transistors T4 verbunden, welche ebenfalls Bestandteil des Mischers MI sind. In Figur 3 sind die beiden Transistoren T1 und T2 sowie die beiden Transistoren T3 und T4 emittergekoppelt und jeweils mit dem Kollektor eines fünften bzw. eines sechsten Transistors T5 bzw. T6 verbunden. Der Basisanschluß des fünften Transistors T5 ist mit dem Eingang inif, der Basisanschluß des sechsten Transistors T6 mit dem Eingang inifx, der Basisanschluß des ersten Transistors T1 mit dem Eingang loinx sowie dem Basisanschluß des vierten Transistors T4 und der Basisanschluß des dritten Transistors T3 ist mit dem Eingang loinx und dem Basisanschluß des zweiten Transistors T2 verbunden. Weiterhin sind die Kollektoren der Transistoren T1 und T3 sowie die Kollektoren der Transistoren T2 und T4 miteinander verbunden. Zwischen die Emitter der Transistoren T5 und T6 ist ein Widerstand RE geschaltet. Der Basisanschluß des Transistors T5 ist mit dem Eingang inif und der Basisanschluß des Transistors T6 istmit dem Eingang inifx verbunden. Der Buchstabe "x" kennzeichnet den invertierten Anschluß.

Der die Transistoren T1 bis T6 und den Widerstand RE umfassende Mischer MI gemäß Figur 3 stellt lediglich ein mögliches Ausführungsbeispiel eines Mischers dar. Es können auch andere Mischerschaltungen anstelle der gerade beschriebenen verwendet werden.

Über den 3-Leiter-Bus 3L werden die Schalter S angesteuert, und dadurch die gewünschte Stromstärke bzw. die gewünschte Spannung zur Offsetkompensation eingestellt.

Die Widerstände R1 bis R5 und R1' bis R5' können wie folgt aufgeteilt sein:

$$R1 = R2 = R$$

$$R3 = 2R$$

$$R4 = 4R$$

$$R5 = 8R$$

Das gleiche gilt für. die Widerstände R1' bis R5'. Die Dimensionierung und die Widerstandsverhältnisse zwischen R1 und R2 bis R5 sind je nach Anwendungsfall auf die jeweiligen Gegebenheiten anzupassen.

Die Ausführungsform gemäß Figur 3 hat den zusätzlichen Vorteil, daß das Widerstands-Stromquellennetzwerk noch einfacher herzustellen ist, als die Stelleinheit (SE) der Anordnung gemäß Figur 2.

Die Arbeitswiderstände des Mischers MI sind in Figur 3 in mehrere, in Serie geschaltete Einzelwiderstände R1 bis R5 bzw. R1' bis R5' aufgeteilt.

Wie bei der in Figur 2 gezeigten Ausführungsform muß bei der in Figur 3 gezeigten Ausführungsform die Kompensation der Offsetspannung nur ein einziges Mal und zwar bei der ersten Inbetriebnahme durchgeführt werden. Hierbei wird bei nicht angelegten Nutzsignalen die Offsetspannung im nachgeschalteten Basisbandbaustein IC2 gemessen und je nach der Größe der Offsetspannung werden über den 3-Leiter-Bus 3L die entsprechenden Stromquellen über die Schalter S aktiviert.

Vorteilhafterweise wird der Offsetkorrekturwert in einem ROM des Basisbandbausteins IC2 abgelegt. Bei jeder neuen Inbetriebnahme des Geräts wird beim Laden des 3-Leiter-Büses 3L die Offsetkompensation automatisch durchgeführt. Dazu ist nurmehr der Wert aus dem ROM auszulesen und die entsprechenden Stromquellen sind zu aktivieren.

Die Erfassung des Offsets des Mischers MI kann durch den im Basisbandbaustein IC2 bereits vorhandenen Analog-Digital-Wandler erfolgen. Dies hat den Vorteil, daß keine zusätzlichen Schaltungselemente für die Erfassung des Offsets des Mischers benötigt werden.

Weiterhin werden durch die in den Figuren 2 und 3 gezeigten Ausführungsformen externe Bauteile und Anschlüsse an dem integrierten Baustein IC1 vermieden.

**Patentansprüche**

1. Anordnung zur Kompensation des Offsets eines Mischers,

   - bei der ein erster integrierter Schaltkreis (IC1) vorgesehen ist, der den Mischer (M) und eine Stelleinheit (SE) zur Erzeugung'eines Offsetkompensationswerts aufweist, welche mit dem Mischer (MI) verbunden ist,
   - bei der ein Bus (3L) vorgesehen ist,
   - bei der ein zweiter integrierter Schaltkreis (IC2) vorgesehen ist, der ein Mittel zur Erfassung (E) des Offsets des Mischers (MI) aufweist und den erfassten Offset auf den Bus (3L) ausgibt,
   - bei der der Offset über den Bus (3L) der Stelleinheit (SE) zugeführt wird.

**2.** Anordnung nach Anspruch 1,
bei der die Stelleinheit (SE) eine oder mehrere einstellbare Stromquellen (I1, I2) aufweist.

**3.** Anordnung nach Anspruch 2,
bei der die einstellbare Stromquelle (SI1, SI2) mehrere zuschaltbare parallel zueinander geschaltete Konstantstromquellen (i, 2i, 4i, 8i) aufweist.

**4.** Anordnung nach Anspruch 1,
bei der die Stelleinheit (SE) mehrere in Reihe geschaltete Widerstände (R1, R3, R4, R5, R6) und mehrere zuschaltbare Stromquellen (i) aufweist, die mit den Widerständen (R1, R3, R4, R5, R6) derart verbunden sind, daß verschiedene Spannungen einstellbar sind.

**5.** Anordnung nach einem der Ansprüche 1 bis 4,
bei der ein Speicher vorgesehen ist, in den der Offsetkompensationswert geschrieben wird.

**6.** Anordnung nach Anspruch 5,
bei der der Speicher ein nichtflüchtiges Element ist.

**7.** Anordnung nach einem der Ansprüche 1 bis 6,
bei der der Bus (3L) ein 3-Leiter-Bus ist.

**8.** Verfahren zur Kompensation des Offsets eines Mischers,

- bei dem der Mischer (MI), welcher Bestandteil eines ersten integrierten Schaltkreises (IC1) ist, ohne Eingangssignal betrieben wird und der Offset des Ausgangssignals das Mischers (MI) mit einem Mittel zur Erfassung (E) des Offsets des Mischers (MI), welches Bestandteil eines zweiten integrierten Schaltkreises (IC2) ist, erfasst wird,
- bei dem der erfasste Offset über einen Bus (3L) an eine Stelleinheit (SE), welche Bestandteil des ersten integrierten Schaltkreises (IC1) ist, übermittelt wird,
- bei dem die Stelleinheit (SE) einen entsprechenden Offsetkompensationswert dem Mischer (MI) zuführt.

**9.** Verfahren nach Anspruch 8,

- bei dem der erfasste Offset in einen nichtflüchtigen Speicher geschrieben wird,
- bei dem der im Speicher stehende Offset bei einer Inbetriebnahme des ersten integrierten Schaltkreises (IC1) ausgelesen wird und über den Bus (3L) der Stelleinheit (SE). zur Verfügung gestellt wird.

**Claims**

**1.** Arrangement for compensation for the offset of a mixer,

- in which a first integrated circuit (IC1) is provided, which has the mixer (M) and a control unit (SE) for producing an offset compensation value and which is connected to the mixer (MI),
- in which a bus (3L) is provided,
- in which a second integrated circuit (IC2) is provided, which has a means for detection (E) of the offset of the mixer (MI) and which outputs the detected offset to the bus (3L), and
- in which the offset is supplied via the bus (3L) to the control unit (SE).

**2.** Arrangement according to Claim 1,
in which the control unit (SE) has one or more variable current sources (I1, I2).

**3.** Arrangement according to Claim 2,
in which the variable current source (SI1, SI2) has two or more constant current sources (i, 2i, 2i, 8i) which can be connected in parallel with one another.

**4.** Arrangement according to Claim 1,
in which the control unit (SE) has two or more series-connected resistors (R1, R3, R4, R5, R6) and two or more current sources (i) which can be connected and are connected to the resistors (R1, R3, R4, R5, R6) such that different voltages can be set.

**5.** Arrangement according to one of Claims 1 to 4,
in which a memory is provided, to which the offset compensation value is written.

**6.** Arrangement according to Claim 5,
in which the memory is a nonvolatile element.

**7.** Arrangement according to one of Claims 1 to 6,
in which the bus (3L) is a 3-conductor bus.

**8.** Method for compensation for the offset of a mixer,

- in which the mixer (MI), which is a component of a first integrated circuit (IC1), is operated without any input signal, and the offset in the output signal of the mixer (MI) is detected by a means for detection (E) of the offset of the mixer (MI), which means is a component of a second integrated circuit (IC2),
- in which the detected offset is transmitted via a bus (3L) to a control unit (SE) which is a component of the first integrated circuit (IC1), and
- in which the control unit (SE) supplies a corresponding offset compensation value to the mixer (MI).

**9.** Method according to Claim 8,

- in which the detected offset is written to a nonvolatile memory,
- in which the offset which is contained in the memory is read when the first integrated circuit (IC1) is started up, and is made available to the control unit (SE) via the bus (3L).

**Revendications**

**1.** Dispositif de compensation de la tension d'offset d'un mélangeur,

- dans lequel il est prévu un premier circuit (IC1) intégré qui comporte le mélangeur (M) et une unité (SE) de réglage, qui est destinée à produire une valeur de compensation de la tension d'offset et qui est reliée au mélangeur (MI),
- dans lequel il est prévu un bus (3L),
- dans lequel il est prévu un deuxième circuit (IC2) intégré qui comporte un moyen de détection (E) de la tension d'offset du mélangeur (MI) et qui envoie la tension d'offset détectée au bus (3L),
- dans lequel la tension d'offset est envoyée à l'unité (SE) de réglage par le bus (3L).

**2.** Dispositif suivant la revendication 1,
dans lequel l'unité (SE) de réglage comporte une ou plusieurs sources (I1, I2) réglables de courant.

**3.** Dispositif suivant la revendication 2,
dans lequel la source (SI1, SI2) réglable de courant comporte plusieurs sources (i, 2i, 4i, 8i) de courant constant pouvant être mises en circuit et montées en parallèle les unes avec les autres.

**4.** Dispositif suivant la revendication 1,
dans lequel l'unité (SE) de réglage comporte plusieurs résistances (R1, R3, R4, R5, R6) montées en série et plusieurs sources (i) de courant pouvant être mises en circuit qui sont reliées aux résistances (R1, R3, R4, R5, R6) de façon à pouvoir établir diverses tensions.

**5.** Dispositif suivant l'une quelconque des revendications 1 à 4,
dans lequel il est prévu une mémoire dans laquelle la valeur de compensation de la tension d'offset est enregistrée.

**6.** Dispositif suivant la revendication 5,
dans lequel la mémoire est un élément non volatil.

**7.** Dispositif suivant l'une des revendications 1 à 6,
dans lequel le bus (3L) est un bus à 3 conducteurs.

**8.** Procédé de compensation de la tension d'offset d'un mélangeur,

- dans lequel on fait fonctionner le mélangeur (MI) qui fait partie d'un premier circuit (IC1) intégré sans signal d'entrée et l'on détecte la tension d'offset du signal de sortie du mélangeur (MI) par un moyen de détection (E) de la tension d'offset du mélangeur (MI), qui fait partie d'un deuxième circuit (IC2) intégré,
- dans lequel on transmet la tension d'offset détectée par un bus (3L) à une unité (SE) de réglage, qui fait partie du premier circuit (IC1) intégré,
- dans lequel l'unité (SE) de réglage envoie au mélangeur (MI) une valeur de compensation correspondante de la tension d'offset.

**9.** Procédé suivant la revendication 8,

- dans lequel on enregistre la tension d'offset détectée dans une mémoire non volatile,
- dans lequel on lit la tension d'offset se trouvant dans la mémoire lors d'une mise en fonctionnement du premier circuit (IC1) intégré et on la met à disposition de l'unité (SE) de réglage par le bus (3L).

FIG 1

# FIG 2

FIG 3